# EUROPEAN PATENT SPECIFICATION

(11) **EP 1 381 230 B1**
(45) Date of publication and mention of the grant of the patent: **19.01.2005**
(21) Application number: 03015278.9
(22) Date of filing: 07.07.2003
(51) Int. Cl.: H04N 5/44

(54) **Satellite broadcast receiving tuner with compensation of cable loss**
Satelliten-Rundfunkempfäger mit Kompensation von Kabelverlusten
Récepteur de radiodiffusion par satellite avec une compensation de pertes en câble

(30) Priority: 09.07.2002 JP 2002199383
(43) Date of publication of application: 14.01.2004
(73) Proprietor: ALPS ELECTRIC CO., LTD., Ota-ku Tokyo 145 (JP)
(72) Inventor: Kawai, Satoshi, Tokyo 145 (JP)
(74) Representative: Kensett, John Hinton

(56) References cited:
- EP-A- 0 929 149
- EP-A- 1 073 199
- EP-A- 1 104 103

## Description

### BACKGROUND OF THE INVENTION

### 1. Field of the Invention

The present invention relates to a satellite broadcast receiving tuner that tunes in a satellite-broadcasting signal that undergoes conversion into an intermediate frequency band by an outdoor downconverter.

### 2. Description of the Related Art

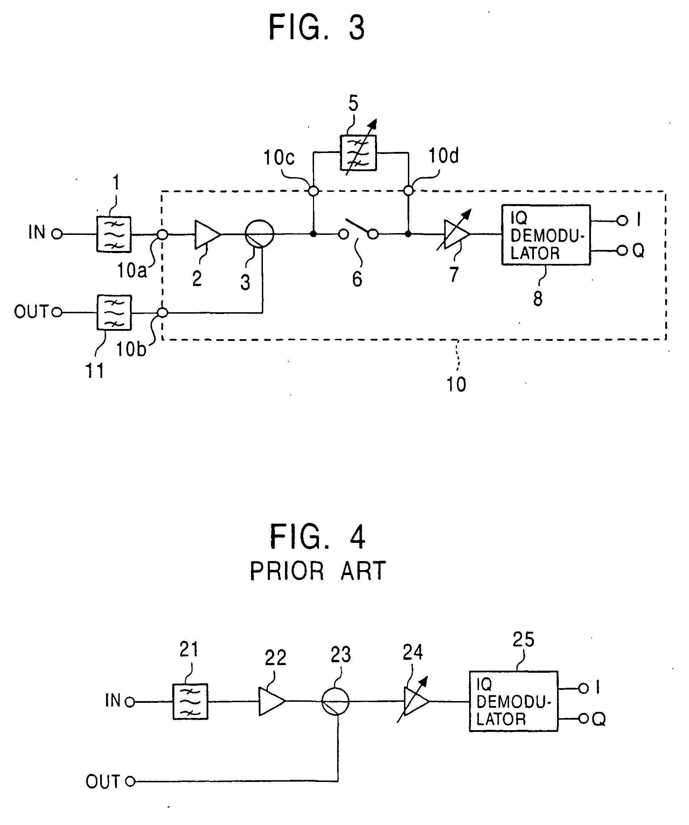

A known satellite broadcast receiving tuner (hereinafter, referred to as a BS tuner) is described with reference to Fig. 4. The satellite-broadcasting signal having a plurality of channels is converted into an intermediate frequency band of approximately 0.95 to 2.15 GHz by an outdoor downconverter (not shown), is brought indoors via a cable (not shown), and is fed via an input terminal (IN) of the BS tuner to a band-pass filter 21. The band-pass filter 21 has a passband of the 0.95 to 2.15 GHz.

The band-pass filter 21 is connected to a first-stage amplifier 22, which is connected to a distributor 23. One output terminal of the distributor 23 is connected to a second-stage amplifier 24. The second-stage amplifier 24 includes a variable gain amplifier and is gain-controlled in accordance with an AGC (Automatic Gain Control) voltage. The satellite-broadcasting signal amplified by the second-stage amplifier 24 is fed into an IQ demodulator 25. A carrier whose frequency is equal to that of the satellite-broadcasting signal to be received is fed from an oscillator (not shown) to the IQ demodulator 25 where the satellite-broadcasting signal to be received is mixed with the carrier into two baseband signals (I signal and Q signal) whose phases intersect each other. Thus, the satellite-broadcasting signal to be received is tuned in by the IQ demodulator 25. The AGC voltage is produced based on the demodulated baseband signal.

The satellite-broadcasting signal output from the other terminal of the distributor 23 is fed into another indoor BS tuner.

In the above construction, the longer the distance between the outdoor downconverter and the indoor BS tuner is, the larger the signal loss due to the cable. Accordingly, a booster amplifier is inserted in the middle of the cable in order to compensate the loss. In addition, when the signal is fed into another BS tuner, another distributor is inserted. In this state, the frequency characteristics of the booster amplifier and the distributor are added to the frequency characteristics of the cable. Compared to the level of the satellite-broadcasting signal in a lower frequency region of the intermediate frequency band fed into the BS tuner, the level of the signal in a higher frequency region is significantly decreased. The difference between the levels of the two frequency regions may be several tens of dB.

When the low-level satellite-broadcasting signal in the higher frequency region is received in such a state, the high-level satellite-broadcasting signal in the lower frequency region causes the second-stage amplifier 24 to be saturated, causing gain compression. This causes a problem in which the insufficient amount of the demodulated baseband signal level occurs since the satellite-broadcasting signal in the higher frequency region cannot be sufficiently amplified.

To solve this problem, it is only required that a band-pass filter whose passband is capable of being shifted over the entire intermediate frequency band is provided between the distributor 23 and the second-stage amplifier 24. However, constructing a band-pass filter whose passband is capable of being shifted over such a wide range of the passband is difficult.

EP-A-0 929 149 describes a tuner in which variable attenuators are located in the RF and the IF paths in order to hold constant the level of the IF signal input to the demodulator. EP-A-1 104103 describes a tuner including a switchable band filter. The switchable filter acts as a trap circuit to avoid that the static capacity of a switch diode in the normal signal path, when in a non-conductive state, changes the frequency selection characteristics of the tuner. EP-A-1 073 199 describes a television tuner including multiple band pass filters of different characteristics switched in parallel in the input path. Successive selection of one filter simulates a tunable input filter.

### SUMMARY OF THE INVENTION

Accordingly, it is an object of the present invention to provide a BS tuner with a simple construction that prevents an amplifier from failing to sufficiently amplify a low-level satellite-broadcasting signal due to gain compression that a high-level satellite-broadcasting signal causes the amplifier to generate when the low-level satellite-broadcasting signal is received.

The invention is set out in the appeaded claims. To this end, there is provided a satellite broadcast receiving tuner including an amplifier for amplifying a plurality of satellite broadcasting signals in an intermediate frequency band, the plurality of satellite broadcasting signals fed through a cable from an outdoor downconverter, an IQ demodulator disposed at the subsequent stage of the amplifier, the IQ demodulator demodulating the satellite broadcasting signals, a switch, and a filter for allowing the satellite broadcasting signals in a higher frequency region of the intermediate frequency band to pass. In the satellite broadcast receiving tuner, the satellite broadcasting signals are fed into the amplifier through one of the switch and the filter.

The filter may include a high-pass filter.

The filter may include a band-pass filter whose passband can be shifted.

Alternatively, the switch, the amplifier, and the IQ demodulator may be integrated in an integrated circuit, which further includes terminals for allowing the filter to be connected in parallel with the switch.

Embodiments of the present invention will now be described, by way of example, with reference to the accompanying diagrammatic drawings, in which:
Fig. 1 is a circuit diagram showing a construction of a satellite broadcast receiving tuner of the present invention;
Fig. 2 is a diagram showing the level of a satellite-broadcasting signal fed into the satellite broadcast receiving tuner of the present invention;
Fig. 3 is a circuit diagram showing another construction of the satellite broadcast receiving tuner of the present invention; and
Fig. 4 is a circuit diagram showing a construction of a known satellite broadcast receiving tuner.

### DESCRIPTION OF THE PREFERRED EMBODIMENTS

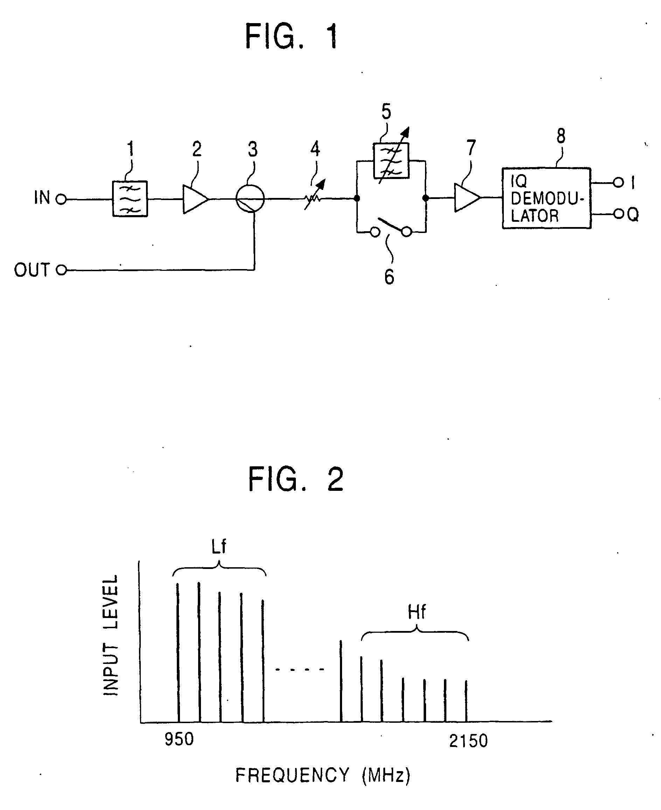

A BS tuner of the present invention will be described with reference to Fig. 1. A satellite broadcasting signal having a plurality of channels is frequency-converted into an intermediate frequency band of approximately 0.95 to 2.15 GHz by an outdoor downconverter (not shown), is brought indoors via a cable (not shown), and is fed via an input terminal (IN) of the BS tuner into the band-pass filter 1. The band-pass filter 1 has a passband of the 0.95 to 2.15 GHz.

The band-pass filter 1 is connected to a first-stage amplifier 2, which is connected to a distributor 3. One output terminal of the distributor 3 is connected to a variable attenuator 4. The variable attenuator 4 is controlled in accordance with the level of the satellite-broadcasting signal to be received. At the subsequent stage of the variable attenuator 4 is disposed a switch 6, which is connected in parallel with a filter 5. The filter 5 includes a band-pass filter or a high-pass filter so as to permit passing of a satellite-broadcasting signal whose frequency is higher than or equal to a predetermined frequency of the intermediate frequency band.

When the filter 5 includes, for example, the band-pass filter, the passband thereof can be shifted so as to be able to accommodate the frequency of the satellite broadcasting signal to be received in a range that is higher than or equal to the predetermined frequency. The switch 6 is controlled so as to be normally ON (closed) and OFF (open) when the satellite-broadcasting signal whose frequency is higher than or equal to the predetermined frequency is received.

A second-stage amplifier (subsequent-stage amplifier) 7 is disposed at the subsequent stage of the switch 6 and the filter 5. An IQ demodulator 8 is disposed at the subsequent stage of the second-stage amplifier 7. The satellite broadcasting signal amplified by the second-stage amplifier 7 is fed into the IQ demodulator 8. A carrier whose frequency is equal to that of the satellite broadcasting signal to be received is fed from an oscillator (not shown) to the IQ demodulator 8 where the satellite broadcasting signal to be received is mixed with the carrier to be converted into two baseband signals (I signal and Q signal) whose phases intersect each other. Therefore, the satellite-broadcasting signal to be received is tuned in by the IQ demodulator 25. The variable attenuator 4 is controlled by an AGC voltage produced based on the demodulated baseband signal.

The satellite-broadcasting signal produced from the other terminal of the distributor 3 is fed into another indoor BS tuner.

As shown in Fig. 2, in the above construction, generally, the level of the satellite broadcasting signal in the band of 0.95 to 2.15 GHz fed to the input terminal (IN) of the BS tuner is high in lower frequency (Lf) channels and low in higher frequency (Hf) channels. This is due to not only that the signal loss occurring in the cable has frequency characteristics but also that the frequency characteristics of a booster amplifier or a distributor provided in the middle are added.

Accordingly, when the satellite broadcasting signal in the higher frequency (Hf) region higher than or equal to the predetermined frequency, the region in which the level thereof is decreased, is received, the switch 6 is turned off, allowing the satellite broadcasting signal produced from the variable attenuator 4 to be fed via the filter 5 to the second-stage amplifier 7. This causes the filter 5 to attenuate a high-level satellite-broadcasting signal in the lower frequency (Lf) region. Before the signal is fed into the second-stage amplifier 7, the level thereof is decreased. As a result of this, since the lower frequency region satellite-broadcasting signal does not cause the second-stage amplifier 7 to be saturated, the gain compression does not occur. Therefore, when the low-level higher frequency region satellite-broadcasting signal is demodulated, the insufficient amount of the baseband signal level does not occur.

When the lower frequency region satellite-broadcasting signal is received, the switch 6 is turned on. In addition, when the level of the satellite-broadcasting signal fed into the input terminal (IN) is determined to be substantially uniform over the above entire intermediate frequency band, the switch 6 is turned on and connecting to the filter 5 is not required.

Referring to Fig. 3, the components following the first-stage amplifier 2 among the construction shown in Fig. 1 are built in an integrated circuit (IC) 10, which is provided with an input terminal 10a and an output terminal 10b to be connected to the filter 5. The satellite-broadcasting signal fed to the input terminal of the BS tuner is input via the band-pass filter 1 to the input terminal 10a. The other output terminal of the distributor 3 is connected to the output terminal 10b of the integrated circuit 10. A band-pass filter 11 provided outside of the integrated circuit 10 is connected to the output terminal 10b Thus, the output from the distributor 3 is fed via the band-pass filter 11 to an output terminal OUT of the BS tuner.

The switch 6 is disposed between the distributor 3 and the second-stage amplifier 7. A node of one output terminal of the distributor 3 and the switch 6 is connected to a filter connection terminal 10c provided in the integrated circuit 10. Likewise, a node of the switch 6 and the second-stage amplifier 7 is connected to a filter connection terminal 10d provided in the integrated circuit 10. Connecting the filter 5 between the two nodes 10c and 10d causes the filter 5 to be connected in parallel with the switch 6. The IQ demodulator 8 is disposed next to the second-stage amplifier 7. In this construction, the variable attenuator 4 in Fig. 1 is not included in the integrated circuit 10. Instead, the second-stage amplifier 7 includes a variable gain amplifier which is gain-controlled by the AGC voltage.

## Claims

1. A satellite broadcast receiving tuner comprising:
an amplifier (7) for amplifying a plurality of satellite broadcasting signals in an intermediate frequency band, the plurality of satellite broadcasting signals fed through a cable from an outdoor downconverter;
an IQ demodulator (8) for demodulating the satellite broadcasting signals;
switching means (6) for allowing the satellite broadcasting signals in the intermediate frequency band to pass or for prohibiting the satellite broadcasting signals from passing; and
a filter (5) connected in parallel with the switching means, for allowing the satellite broadcasting signals in a higher frequency region of the intermediate frequency band to pass; wherein:
when the frequency of a received signal is higher than or equal to a predetermined frequency, the switching means is turned off to input the received signal into the amplifier via the filter; and
when the frequency of the received signal is lower than the predetermined frequency and when the levels of the satellite broadcasting signals in the intermediate frequency band are substantially uniform across the entire band, the switching means is turned on to input the received signal into the amplifier via the switching means.

2. A satellite broadcast receiving tuner according to Claim 1, wherein the filter includes a high-pass filter.

3. A satellite broadcast receiving tuner according to Claim 1, wherein the filter includes a band-pass filter whose passband can be shifted.

4. A satellite broadcast receiving tuner according to any of Claims 1 to 3, wherein:
the switch, the amplifier, and the IQ demodulator are integrated in an integrated circuit; and
the integrated circuit further includes terminals for allowing the filter to be connected in parallel with the switch.

## Patentansprüche

1. Satellitenrundfunkempfangstuner aufweisend:
einen Verstärker (7) zum Verstärken einer Mehrzahl von Satellitenrundfunksignalen in einem Zwischenfrequenzband, wobei die Mehrzahl Satellitenrundfunksignale über ein Kabel von einem aushäusigen Abwärtskonverter zugeführt wird;
einen IQ-Demodulator (8) zum Demodulieren der Satellitenrundfunksignale;
eine Schaltereinrichtung (6), die es ermöglicht, die Satellitenrundfunksignale in dem Zwischenfrequenzband durchzulassen oder die Satellitenrundfunksignale am Durchlass zu hindern; und
ein der Schaltereinrichtung parallel geschaltetes Filter (5), das es den Satellitenrundfunksignalen in einem höheren Frequenzbereich des Zwischenfrequenzbandes erlaubt zu passieren; wobei:
dann, wenn die Frequenz des empfangenen Signals höher ist oder gleich der vorbestimmten Frequenz, die Schaltereinrichtung ausgeschaltet wird, um das empfangene Signal dem Verstärker über das Filter zuzuführen; und
dann, wenn die Frequenz des empfangenen Signals niedriger als die vorbestimmte Frequenz ist und wenn die Pegel der Satellitenrundfunksignale in dem Zwischenfrequenzband im Wesentlichen gleichförmig über das gesamte Band sind, die Schaltereinrichtung ein geschaltet wird, um das empfangene Signal dem Verstärker über die Schaltereinrichtung zu zuführen.

2. Satellitenrundfunkempfangstuner nach Anspruch 1, wobei das Filter ein Hochpassfilter umfasst.

3. Satellitenrundfunkempfangstuner nach Anspruch 1, wobei das Filter ein Bandpassfilter umfasst, dessen Durchlassband verschiebbar ist.

4. Satellitenrundfunkempfangstuner nach einem der Ansprüche 1-3, wobei:
der Schalter, der Verstärker und der IQ-Demodulator in eine integrierte Schaltung integriert sind; und
die integrierte Schaltung außerdem Anschlüsse aufweist, mit welchen sich das Filter dem Schalter parallel schalten lässt.

## Revendications

1. Récepteur de radiodiffusion par satellite comprenant:
un amplificateur (7) pour amplifier une pluralité de signaux de radiodiffusion par satellite dans une bande de fréquences intermédiaires, cette pluralité de signaux de radiodiffusion par satellite étant amenée par un câble à partir d'un convertisseur externe;
un démodulateur (8) des voies I et Q (en abrégé démodulateur IQ), pour démoduler les signaux de radiodiffusion par satellite ;
un moyen commutateur (6) pour permettre le passage des signaux de radiodiffusion par satellite de la bande de fréquences intermédiaires ou empêcher le passage des signaux de radiodiffusion par satellite; et
un filtre (5) connecté en parallèle avec le moyen commutateur, pour permettre le passage des signaux de radiodiffusion par satellite inclus dans une région de fréquences plus hautes de la bande de fréquences intermédiaires; dans lequel
lorsque la fréquence d'un signal reçu est supérieure ou égale à une fréquence prédéterminée, le moyen commutateur est mis hors circuit afin que le signal reçu soit entré dans l'amplificateur à travers le filtre; et
lorsque la fréquence du signal reçu est inférieure à la fréquence prédéterminée, et que les niveaux des signaux de radiodiffusion par satellite de la bande de fréquences intermédiaires sont sensiblement uniformes dans toute la bande, le moyen commutateur est mis en circuit afin que le signal reçu soit entré dans l'amplificateur à travers le moyen commutateur.

2. Récepteur de radiodiffusion par satellite selon la revendication 1, dans lequel le filtre inclut un filtre passe-haut.

3. Récepteur de radiodiffusion par satellite selon la revendication 1, dans lequel le filtre inclut un filtre passe-bande dont la bande de passage peut être décalée.

4. Récepteur de radiodiffusion par satellite selon l'une quelconque des revendications précédentes, dans lequel:
le commutateur, l'amplificateur, et le démodulateur IQ sont intégrés dans un circuit intégré; et
le circuit intégré inclut en outre des bornes pour permettre au filtre d'être connecté en parallèle avec le commutateur.
